# DEMANDE DE BREVET EUROPEEN

(11) **EP 1 039 630 A1**
(43) Date de publication de la demande: **27.09.2000**
(21) Numéro de dépôt: 00400669.8
(22) Date de dépôt: 10.03.2000
(51) Int. Cl.: H03F 1/32

(54) **Dispositif de linéarisation à large bande de fréquences**

(30) Priorité: 18.03.1999 FR 9903396
(71) Demandeur: ALCATEL, 75008 Paris (FR)
(72) Inventeur: Villemazet, Jean-François, 31550 Cintegabelle (FR); Moroni, Pascal, 31300 Toulouse (FR); Cogo, Bernard, 31850 Montrabe (FR)
(74) Mandataire: Smith, Bradford Lee

(57) **Abrégé**

L'invention est relative à un dispositif de linéarisation du gain et de la phase d'un amplificateur fonctionnant dans le domaine des hyperfréquences comprenant des moyens pour conférer une pré-distorsion du gain et de la phase qui compense les non-linéarités en gain et en phase de l'amplificateur correspondant, notamment du type à tube(s) électronique(s).

Il est caractérisé en ce qu'il comporte : une première voie (46) recevant le signal d'entrée et qui comporte une diode Schottky (62) montée en série, une seconde voie (48) qui reçoit aussi le signal d'entrée et qui comporte au moins une diode Schottky (90, 92) montée en parallèle, et un coupleur (52) pour mettre en phase les signaux fournis par la première et la seconde voies.

## Description

L'invention est relative à un dispositif de linéarisation pour amplificateur à large bande de fréquences, notamment dans le domaine des hyperfréquences.

Lorsque les besoins en puissance de signaux électroniques sont importants, on fait appel à un amplificateur que l'on fait fonctionner au voisinage de sa puissance de saturation. On citera ici, à titre d'exemple, les besoins en émission de satellites de télécommunications pour lesquels on utilise souvent des amplificateurs à tube(s) à onde progressive.

Le fonctionnement proche de la saturation entraîne une réponse non linéaire de l'amplificateur. De façon plus précise, quand la puissance d'entrée est sensiblement plus faible que la puissance de saturation, la puissance de sortie est sensiblement proportionnelle à la puissance d'entrée. Par contre, quand la puissance d'entrée se rapproche de la puissance de saturation, le gain diminue, pour prendre la valeur 1 à la saturation. Ce défaut de linéarité se traduit aussi sur la phase du signal de sortie : cette phase est constante quand l'amplificateur fonctionne en dehors de la zone de saturation et, pour certains amplificateurs (notamment ceux à tube à onde progressive), diminue quand la puissance se rapproche de la valeur de saturation.

Pour remédier à cet inconvénient, on utilise couramment, notamment pour les amplificateurs à tube pour lesquels le gain et la phase diminuent quand la puissance d'entrée s'approche de la valeur de saturation, des dispositifs de linéarisation à pré-distorsion. Un tel dispositif est disposé en amont de l'amplificateur ou du tube à linéariser. Il fournit un signal de sortie dont l'amplitude et la phase varient en fonction de la puissance d'entrée d'une manière non linéaire et de façon telle que l'amplitude et la phase du signal de sortie de l'amplificateur varient de façon linéaire en fonction de la puissance du signal à l'entrée du dispositif de pré-distorsion.

De façon plus précise, dans le dispositif de linéarisation, on applique tant au gain qu'à la phase, une pré-distorsion qui garde le gain et la phase constants pour les valeurs de la puissance d'entrée sensiblement inférieures à la puissance de saturation et un gain et une phase qui augmentent quand la puissance d'entrée se rapproche de la puissance de saturation, ce qui permet de compenser la diminution du gain et de la phase de l'amplificateur.

Les dispositifs de pré-distorsion connus jusqu'à présent qui peuvent être utilisés pour des applications spatiales ne fonctionnent correctement que pour des bandes de fréquences de valeurs relativement faibles, par exemple de 250 à 500 MHz, dans une gamme de fréquences comprise entre 10,7 et 12,75 GHz.

On connaît par ailleurs des dispositifs de linéarisation pour des tubes amplificateurs qui peuvent fonctionner sur une large bande de fréquences, notamment une bande de 1,5 à 2 GHz en bande Ku. Toutefois, les dispositifs connus présentent des structures complexes faisant appel à plusieurs circuits intégrés hyperfréquences. Leur réglage est délicat et ils sont sensibles à la température. En outre, ils sont, en général, d'un prix élevé et sont encombrants, ce qui constitue un inconvénient grave pour de nombreuses applications, notamment les applications spatiales.

Le dispositif selon l'invention permet une linéarisation sur une large bande de fréquences. Il peut être réalisé à faible coût et par une technique de circuit intégré hyperfréquence.

Le dispositif de linéarisation selon l'invention, qui fonctionne dans le domaine des hyperfréquences, comprend un coupleur d'entrée séparant ce signal d'entrée en deux signaux en phase dont l'un est délivré à une première voie à diode Schottky montée en série et l'autre à une seconde voie à au moins une diode Schottky montée en parallèle, les signaux de sortie des deux voies étant remis en phase par un coupleur de sortie, de préférence un coupleur à 180°.

La voie à diode Schottky en série confère la pré-distorsion en phase. Par contre, elle renforce la distorsion du gain. La voie à diode(s) Schottky en parallèle garde la phase constante, mais augmente le gain. Cette dernière permet de compenser la distorsion parasite de gain introduite dans la voie à diode en série et de fournir, au moins partiellement, la pré-distorsion nécessaire sur le gain.

Il est préférable que la voie à diode montée en parallèle comporte au moins deux diodes Schottky montées en parallèle.

Dans le mode de réalisation préféré, la sortie du coupleur, notamment à 180°, est reliée à la sortie du dispositif de pré-distorsion par une troisième voie à au moins une diode Schottky montée en parallèle.

Cette troisième voie complète la pré-distorsion du gain obtenue par la deuxième voie, également à diode(s) Schottky montée(s) en parallèle. On a constaté que les meilleurs résultats étaient obtenus en prévoyant deux diodes montées en parallèle dans cette troisième voie.

Il est préférable d'appliquer des tensions continues de polarisation réglables sur les diodes dans chaque voie, de façon à permettre, dans la voie à diode montée en série, un réglage de la pré-distorsion de phase et, dans la voie, ou les voies, à diode(s) branchée(s) en parallèle, un réglage de pré-distorsion de gain.

Quand on prévoit un coupleur de sortie pour la remise en phase des signaux fournis par les première et seconde voies, il est avantageux de l'associer à un élément de réglage, tel qu'un "stub", qui maintient la remise en phase des signaux des deux premières voies malgré les variations de fréquence et de puissance.

Dans la seconde voie comportant au moins une diode Schottky montée en parallèle, on peut aussi prévoir une autre diode Schottky montée en série, en amont de la diode (ou des diodes) montée(s) en parallèle, cette diode en série pouvant améliorer la pré-distorsion de gain.

Ainsi, l'invention prévoit un dispositif de linéarisation d'amplificateur du type à pré-distorsion qui comprend deux voies recevant chacune le signal d'entrée, la première permettant de conférer une pré-distorsion de phase et la seconde, permettant de conférer une pré-distorsion de gain, les deux voies alimentant un coupleur permettant de mettre en phase les signaux de sortie sur ces deux voies.

Dans le mode de réalisation préféré, le coupleur de remise en phase est relié à l'entrée de l'amplificateur à linéariser par l'intermédiaire d'une voie supplémentaire permettant un réglage complémentaire de la pré-distorsion de gain et/ou de phase.

La présente invention prévoit un dispositif de linéarisation du gain et de la phase d'un amplificateur fonctionnant dans le domaine des hyperfréquences comprenant des moyens pour conférer une pré-distorsion du gain et de la phase qui compense les non-linéarités en gain et en phase de l'amplificateur correspondant, notamment du type à tube(s) électronique(s), et qui comporte une première voie recevant le signal d'entrée et qui comporte une diode Schottky montée en série, une seconde voie qui reçoit aussi le signal d'entrée et qui comporte au moins une diode Schottky montée en parallèle, et un coupleur pour mettre en phase les signaux fournis par la première et la seconde voies.

Selon un mode de réalisation, la seconde voie comporte deux diodes Schottky montées en parallèle.

Selon un mode de réalisation, le dispositif comporte une troisième voie, montée à la sortie du coupleur et qui comprend au moins une diode Schottky montée en parallèle.

La troisième voie peut aussi comporter deux diodes Schottky montées en parallèle.

Selon un mode de réalisation, chacune des voies comporte une entrée pour une polarisation continue de réglage des pré-distorsions de gain et de phase.

Cette polarisation continue est, par exemple, appliquée par l'intermédiaire d'une résistance de réglage ajustable.

Selon un mode de réalisation, le coupleur destiné à remettre en phase les signaux délivrés par la première et la seconde voies est du type 180°, par exemple à trois lignes de transmission.

Selon un mode de réalisation, le dispositif comporte un coupleur d'entrée présentant deux sorties en phase auxquelles sont connectées, respectivement, la première et la seconde voies.

Ce coupleur d'entrée est, par exemple, du type Wilkinson.

Selon un mode de réalisation, le dispositif comporte un organe permettant de maintenir la phase du coupleur de sortie constante malgré les variations de la puissance d'entrée et de la fréquence.

Selon un mode de réalisation, une diode Schottky est montée en série dans la seconde voie en amont de la (les) diode(s) montée(s) en parallèle.

Selon un mode de réalisation, toutes les diodes sont identiques.

L'invention prévoit en outre une application du dispositif à la linéarisation d'un amplificateur à tube électronique destiné à être monté à bord d'un engin spatial, notamment d'un satellite de télécommunications.

D'autres caractéristiques et avantages de l'invention apparaîtront avec la description de certains de ses modes de réalisation, celle-ci étant effectuée en se référant aux dessins ci-annexés sur lesquels :
la figure 1 est un schéma d'un amplificateur et d'un dispositif de pré-distorsion,
les figures 1a à 1c sont des diagrammes montrant le fonctionnement du dispositif de linéarisation associé à l'amplificateur, et
la figure 2 est un schéma d'un mode de réalisation de dispositif de linéarisation conforme à l'invention avec des diagrammes montrant certains aspects de son fonctionnement, et
la figure 2a montre une partie du dispositif de la figure 2, pour une variante.

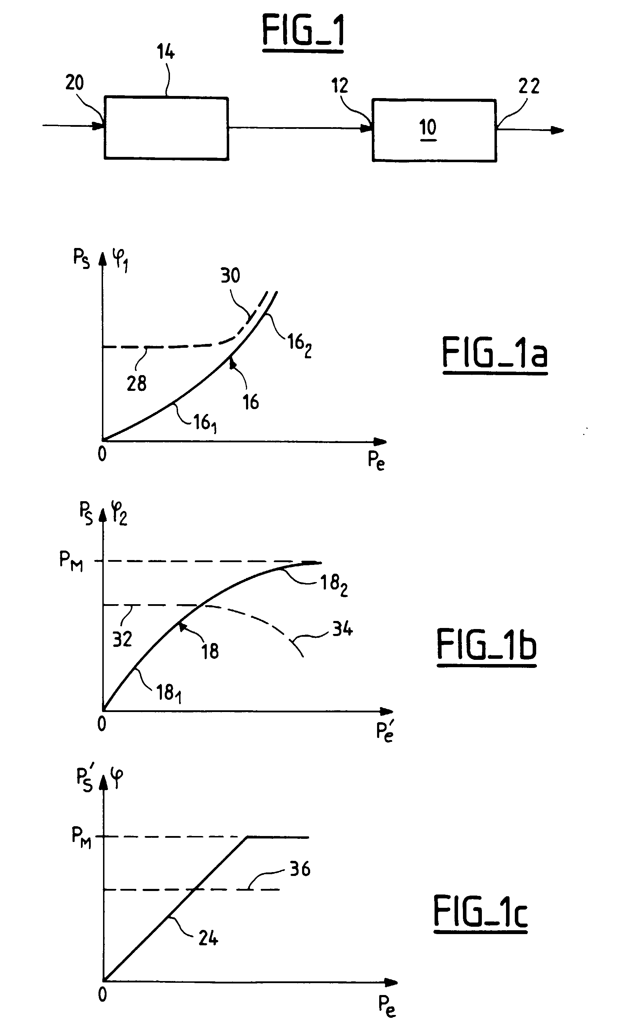

Sur la figure 1, on a représenté un amplificateur de puissance 10 à tube destiné, par exemple, à être embarqué à bord d'un engin spatial tel qu'un satellite de façon à alimenter une ou des antennes d'émission (non montrées) d'un système de télécommunications. Le signal à amplifier est appliqué sur l'entrée 12 de cet amplificateur 10 par l'intermédiaire d'un dispositif 14 de linéarisation du type à pré-distorsion.

Sur le diagramme de la figure 1a, on a porté en abscisses, la puissance Pₑ d'entrée et, en ordonnées, la puissance Pₛ de sortie. La courbe 16 sur ce diagramme correspond au dispositif 14 de linéarisation. On voit que la courbe 16 présente, pour les faibles puissances d'entrée, une partie linéaire 16₁ et, pour les valeurs les plus élevées de la puissance d'entrée, une partie non linéaire16₂ dont la pente est plus élevée que celle de la partie linéaire 16₁.

Le diagramme de la figure 1b correspond au fonctionnement de l'amplificateur 10 à tube à onde progressive. Ce diagramme est analogue à celui de la figure 1a. La courbe 18 présente une première partie 18₁ linéaire et une seconde partie 18₂ non-linéaire pour les valeurs les plus élevées de la puissance de sortie P_{S}, quand cette dernière se rapproche de la puissance P_{M} de saturation. Dans la partie 18₂, la pente est plus faible que la pente de la partie linéaire 18₁ et se rapproche de zéro.

Sur le diagramme de la figure 1c, on a montré la relation entre le signal Pₑ à l'entrée 20 du dispositif 14 et le signal P'ₛ sur la sortie 22 de l'amplificateur 10. On voit que la courbe de variation de P'ₛ en fonction de Pₑ présente, jusqu'à la saturation P_{M}, une variation linéaire 24.

Sur les diagrammes des figures 1a à 1c, on a aussi représenté, en traits interrompus, les variations de la phase ϕ des signaux de sortie en fonction des puissances Pₑ ou P'ₑ des signaux d'entrée. On voit sur la figure 1a que la phase ϕ₁ du signal sur la sortie du dispositif 14 reste constante (partie plate 28) pour les valeurs les plus faibles de la puissance d'entrée Pₑ et augmente de façon non linéaire (partie 30) pour les puissances d'entrée qui se rapprochent de la puissance de saturation.

On voit sur la figure 1b que la phase ϕ₂ du signal sur la sortie 22 de l'amplificateur 10 est constante pour les plus faibles valeurs de la puissance Pₑ' sur l'entrée 12 et décroît de façon non linéaire (partie 34) quand cette puissance d'entrée se rapproche de la puissance de saturation.

Sur la figure 1c, on voit que la phase du signal sur la sortie 22 reste constante (droite 36).

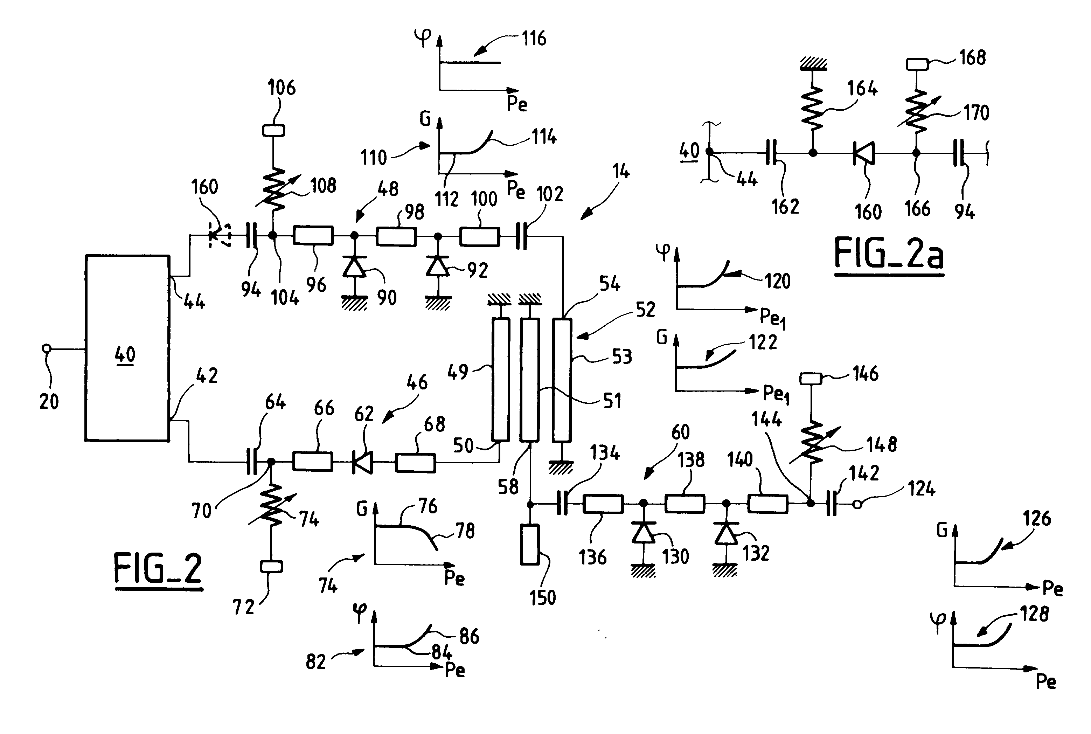

Le mode de réalisation de l'invention qui est représenté sur la figure 2 est un dispositif de linéarisation pour tube ou amplificateur destiné à être monté à bord d'un satellite de réémission de signaux. Ce dispositif de linéarisation est destiné à être associé à un amplificateur fonctionnant entre 11 et 12,5 GHz, c'est-à-dire avec une bande passante de 1,5 GHz. Cette bande passante peut atteindre 2 GHz en bande C ou en bande Ka.

Ce dispositif de linéarisation est du type à pré-distorsion, comme le dispositif 14 représenté sur la figure 1.

Le signal sur l'entrée 20 est associé à un coupleur 40 de type Wilkinson présentant deux sorties 42 et 44 sur lesquelles les signaux sont identiques en amplitude et en phase. On sait qu'un coupleur permet d'isoler les sorties 40 et 42 l'une par rapport à l'autre.

La sortie 42 alimente une première voie 46 destinée à effectuer la pré-distorsion de phase et la sortie 44 est reliée à une voie 48 destinée à effectuer une pré-distorsion de gain.

La sortie de la voie 46 est reliée à la première entrée 50 d'un coupleur 52 du type 180° triligne dont la seconde entrée 54 reçoit le signal de sortie de la seconde voie 48. Le rôle du coupleur 52 est de remettre en phase les signaux des voies 46 et 48 qui sont en opposition de phase. La sortie 58 du coupleur 52 est reliée à une troisième voie 60 complétant la pré-distorsion en gain effectuée par la seconde voie 48.

La première voie 46 comporte une diode Schottky 62 montée en série. Dans cette voie, la sortie 42 du coupleur 40 est reliée à la cathode de la diode 62 par l'intermédiaire d'un condensateur 64 et d'une ligne de transmission 66 en série. L'anode de la diode 62 est reliée à l'entrée 50 du coupleur 52 par l'intermédiaire d'une autre ligne de transmission 68. L'entrée 50 est reliée à la masse par l'intermédiaire d'une ligne 49 du coupleur 52.

Le point commun 70 au condensateur 64 et à la résistance 66 est relié à une borne 72 par l'intermédiaire d'une résistance réglable 74. Sur la borne 72 est appliquée une tension continue réglable de polarisation qui permet de régler la polarisation de la diode 62 et donc d'ajuster la caractéristique de pré-distorsion de phase conférée par cette voie 46.

De façon classique, le condensateur 64 a pour but l'éliminer la composante continue du signal appliqué sur l'entrée 42.

Le diagramme 74 montre la variation du gain G de cette voie 46 en fonction de la puissance d'entrée, c'est-à-dire de la puissance du signal sur la sortie 42 du coupleur 40. Le gain est le rapport entre la puissance du signal sur l'entrée 50 du coupleur 52 et la puissance du signal sur la sortie 42 du coupleur 40. Ce gain a une valeur constante, comme montré par la partie 76 du diagramme 74, et décroît quand la puissance d'entrée se rapproche de la saturation, comme montré par la partie 78 du diagramme 74. Cette propriété de la voie ou branche 46 n'est pas favorable à la pré-distorsion. Comme on le verra plus loin, cette caractéristique de la voie 46 est corrigée par les voies 48 et 60.

Par contre, comme montré par le diagramme 82, la voie 46 effectue la pré-distorsion recherchée sur la phase. En effet, on a représenté sur ce diagramme 82, en abscisses, la puissance Pₑ sur la sortie 42 du coupleur 40 et, en ordonnées, la phase ϕ du signal appliqué sur l'entrée 50 du coupleur 52. Cette phase ϕ est constante pour les plus faibles valeurs de Pₑ, comme le montre la partie 84 du diagramme 82 et augmente quand Pₑ se rapproche de la puissance de saturation, comme montré par la partie 86 du même diagramme 82.

Dans la seconde voie 48, on prévoit deux diodes Schottky 90 et 92 montées en parallèle, leurs anodes étant reliées à la masse. La cathode de la diode 90 est reliée à la sortie 44 du coupleur 40 par l'intermédiaire d'un condensateur 94 et d'une ligne de transmission 96 en série. La cathode de la diode 90, et donc aussi la ligne de transmission 96, est reliée à la cathode de la diode 92 par l'intermédiaire d'une autre ligne de transmission 98. La cathode de la diode 92 est reliée à l'entrée 54 du coupleur 52 par l'intermédiaire d'une ligne de transmission 100 et d'un condensateur 102 en série.

Le point commun 104 au condensateur 94 et à la ligne 96 est relié à une borne 106 par l'intermédiaire d'une résistance réglable 108. Sur la borne 106 est appliquée une tension ou polarisation continue de réglage de la polarisation des diodes 90 et 92 permettant d'ajuster la pré-distorsion de gain réalisée par cette voie 48.

Comme le montre le diagramme 110, cette voie 48 effectue partiellement la pré-distorsion recherchée du gain, c'est-à-dire que, pour les faibles valeurs de la puissance d'entrée, c'est-à-dire de la puissance sur la borne 44, le gain est constant (partie 112 du diagramme 110) et, pour les valeurs plus importantes de la puissance d'entrée, le gain augmente (partie 114 du diagramme 110). La voie 48 n'a pas d'effet sur la phase, comme montré par le diagramme 116, c'est-à-dire que la phase sur l'entrée 54 du coupleur 52 reste constante quand la puissance sur la borne 44 varie.

Sur la sortie 58 du coupleur 52, on obtient, pour la phase, le signal représenté par le diagramme 120, qui est identique au diagramme 82. Sur ce diagramme 120, on a porté en abscisses la puissance Pₑ₁ du signal appliqué sur l'entrée 20 du coupleur 40 et, en ordonnées, la phase ϕ du signal sur la sortie 58.

On a représenté sur le diagramme 122 le gain du signal sur la sortie 58 en fonction de la puissance Pₑ₁. La pré-distorsion de gain ainsi obtenue est insuffisante pour linéariser l'amplificateur auquel doit être associé le dispositif représenté sur la figure 2, car la voie 48 a surtout pour but de corriger la distorsion parasite conférée par le gain par la voie 46 (diagramme 74).

Le coupleur 52 comprend une première ligne de transmission 49 entre l'entrée 50 et la masse, une seconde ligne 51 de transmission entre la sortie 58 et la masse, et une troisième ligne 53 de transmission entre l'entrée 54 et la masse. Les trois lignes 49, 51 et 53 sont parallèles et la ligne 51 est disposée entre les lignes 49 et 53.

La voie 60 maintient la correction de phase conférée par la voie 46 à diode 62 en série, tandis qu'elle renforce la pré-distorsion de gain conférée par la voie 48 à diodes en parallèle. Ainsi, sur la sortie 124, on obtient les pré-distorsions voulues de gain et de phase (diagrammes 126 et 128).

La voie 60 est analogue à la voie 48, c'est-à-dire qu'elle comporte deux diodes Schottky 130 et 132 montées en parallèle. Ainsi, les anodes des diodes 130 et 132 sont connectées à la masse. La cathode de la diode 130 est reliée à la sortie 58 du coupleur 52 par l'intermédiaire d'un condensateur 134 et d'une résistance ou ligne de transmission 136 en série. La cathode de la diode 130 est également reliée à la cathode de la diode 132 par l'intermédiaire d'une autre ligne de transmission 138. La cathode de la diode 132 est reliée à la sortie 124 par l'intermédiaire d'une ligne de transmission 140 et d'un condensateur 142 en série. La borne commune 144 à la ligne 140 et au condensateur 142 est reliée à une borne 146 par l'intermédiaire d'une résistance réglable 148. Sur la borne 146, est appliquée une tension ou polarisation continue de réglage destinée à ajuster la courbe 126 de gain.

Enfin, la phase du coupleur 52 est réglée automatiquement grâce à un stub 150 connecté à la sortie 58.

Le dispositif de linéarisation ou linéariseur que l'on vient de décrire en relation avec la figure 2 fonctionne sur une large bande en hyperfréquences. Dans un exemple, il permet la linéarisation d'un amplificateur de 11 à 12,5 GHz.

Dans une variante, on prévoit, dans la voie 48, une diode Schottky 160 (montrée en trait interrompu sur la figure) montée en série, dont la cathode est reliée directement à la sortie 44 du coupleur 40 et dont l'anode est reliée au condensateur 94. Cette diode permet d'améliorer la caractéristique de pré-distorsion de la voie 48 en reculant la partie 114 vers les puissances Pₑ supérieures et en augmentant le caractère exponentiel (arrondi) de cette partie 114.

Dans une variante représentée sur la figure 2a, la diode Schottky 160 montée en série est associée à un circuit de polarisation comportant un condensateur 162 disposé entre la sortie 44 du coupleur 40 et la cathode de la diode 160. Le point commun au condensateur 162 et à la cathode de la diode est relié à la masse par l'intermédiaire d'une résistance 164. Enfin, l'anode de la diode 160 est reliée au condensateur 94 et le point commun 166 à l'anode de la diode et au condensateur 94 est relié à une borne 168 par l'intermédiaire d'une résistance 170 de réglage. La borne 168 est destinée à recevoir une polarisation continue de réglage. Ainsi, cette polarisation ajustable ainsi que la valeur réglable de la résistance 170 confèrent des possibilités supplémentaires de réglage.

Pour un fonctionnement optimal et pour faciliter la fabrication, il est préférable que toutes les diodes du dispositif 14 soient identiques.

Il est à noter que les résistances 74, 108, 148 et 170 sont du type ohmique et donc aisées à ajuster. Leurs valeurs sont élevées pour bloquer les signaux hyperfréquences. Cette valeur est de plusieurs kiloohms. Ces résistances ont un effet seulement en courant continu. Il s'agit d'éléments courants et aisés à mettre en oeuvre. Ces résistances confèrent une auto-polarisation différente aux diodes associées.

Le dispositif 14 représenté sur la figure 2 peut être réalisé de façon aisée. Pour obtenir les gains et les phases corrects, on calcule, par des procédés classiques, les longueurs et les largeurs des lignes de transmission 66, 68, 96, 98, 100, 136, 138 et 140. On peut aussi noter que les caractéristiques de l'organe 150 peuvent être aisément calculées pour que le coupleur 52, associé à cet organe 150, confère, quelles que soient la puissance d'entrée et la fréquence, le déphasage nécessaire pour remettre en phase les signaux des voies 46 et 48.

Il est, en principe, possible de se passer de la voie 60. Toutefois, celle-ci facilite les réglages lors de la conception et/ou de l'utilisation.

En outre, la réalisation du dispositif 14 est particulièrement simple car, en dehors des diodes, tous les éléments peuvent être réalisés sous forme de circuits gravés. Par ailleurs, les réglages sont effectués à l'aide de tensions continues et de résistances de polarisation en courant continu, ce qui est beaucoup plus simple qu'un réglage en hyperfréquence.

Il présente une excellente stabilité en température. Le coût et la masse du dispositif peuvent être particulièrement faibles. Enfin, il peut être réalisé sous forme de circuit intégré en technique dite "MMIC" pour les circuits hyperfréquences.

## Revendications

1. Dispositif de linéarisation du gain et de la phase d'un amplificateur fonctionnant dans le domaine des hyperfréquences comprenant des moyens pour conférer une pré-distorsion du gain et de la phase qui compense les non-linéarités en gain et en phase de l'amplificateur correspondant, notamment du type à tube(s) électronique(s), caractérisé en ce qu'il comporte une première voie (46) recevant le signal d'entrée et qui comporte une diode Schottky (62) montée en série, une seconde voie (48) qui reçoit aussi le signal d'entrée et qui comporte au moins une diode Schottky (90, 92) montée en parallèle, et un coupleur (52) pour mettre en phase les signaux fournis par la première et la seconde voies.

2. Dispositif selon la revendication 1 ou 2, caractérisé en ce que la seconde voie comporte deux diodes Schottky montées en parallèle (90, 92).

3. Dispositif selon la revendication 1 ou 2, caractérisé en ce qu'il comporte une troisième voie, montée à la sortie (58) du coupleur (52) et qui comprend au moins une diode Schottky (130, 132) montée en parallèle.

4. Dispositif selon la revendication 3, caractérisé en ce que la troisième voie comporte deux diodes (130, 132) Schottky montées en parallèle.

5. Dispositif selon l'une quelconque des revendications précédentes, caractérisé en ce que chacune des voies comporte une entrée (72, 106, 146) pour une polarisation continue de réglage des pré-distorsions de gain et de phase.

6. Dispositif selon la revendication 5, caractérisé en ce que la polarisation continue est appliquée par l'intermédiaire d'une résistance de réglage (74, 108, 148) ajustable.

7. Dispositif selon l'une quelconque des revendications précédentes, caractérisé en ce que le coupleur (52) pour remettre en phase les signaux délivrés par la première (46) et la seconde (48) voies est du type 180°, par exemple à trois lignes (49, 51, 53) de transmission.

8. Dispositif selon l'une quelconque des revendications précédentes, caractérisé en ce qu'il comporte un coupleur (40) d'entrée présentant deux sorties (42, 44) en phase auxquelles sont connectées, respectivement, la première (46) et la seconde (48) voies.

9. Dispositif selon la revendication 8, caractérisé en ce que le coupleur d'entrée (40) est du type Wilkinson.

10. Dispositif selon l'une quelconque des revendications précédentes, caractérisé en ce qu'il comporte un organe (150) permettant de maintenir la phase du coupleur (52) de sortie constante malgré les variations de la puissance d'entrée et de la fréquence.

11. Dispositif selon l'une quelconque des revendications précédentes, caractérisé en ce qu'une diode Schottky en série (160) est montée dans la seconde voie (48) en amont de la (les) diode(s) montée(s) en parallèle.

12. Dispositif selon l'une quelconque des revendications précédentes, caractérisé en ce que toutes les diodes sont identiques.

13. Application du dispositif selon l'une quelconque des revendications précédentes à la linéarisation d'un amplificateur à tube électronique destiné à être monté à bord d'un engin spatial, notamment d'un satellite de télécommunications.
